# EUROPEAN PATENT APPLICATION

(11) **EP 3 260 278 A1**
(43) Date of publication of application: **27.12.2017**
(21) Application number: 16175369.4
(22) Date of filing: 21.06.2016
(51) Int. Cl.: B29C 67/00, H01L 23/02, H01L 21/48

(54) **COMPONENTS FOR POWER SEMICONDUCTOR MODULES AND ADDITIVE MANUFACTURING THEREOF**

(71) Applicant: Infineon Technologies AG, 85579 Neubiberg (DE)
(72) Inventor: Wilke, Ulrich, 95494 Soest (DE); Cordes, Achim, 59581 Warstein (DE); Mücke, Achim, 59597 Erwitte (DE); Tschirbs, Roman, 59494 Soest (DE); Hohlfeld, Olaf, 59581 Warstein (DE)
(74) Representative: Westphal, Mussgnug & Partner Patentanwälte mbB

(57) **Abstract**

A power semiconductor module comprises a housing part with a surface, a component which is firmly bonded with the surface of the housing part, wherein at least one of the housing part and the component is at least partly manufactured by additive manufacturing.

## Description

### TECHNICAL FIELD

The present application relates to components for power semiconductor modules and additive manufacturing thereof.

### BACKGROUND

Plastic housings of power semiconductor modules are commonly manufactured in large quantities by injection molding. Every kind of housing needs a particular casting. Therefore it is difficult and expensive to adapt housings to particular requirements, requested by customers. Hence, there is a need for an improved production process for power semiconductor modules that allows for easily adapting housings to customer requirements.

### SUMMARY

A power semiconductor module comprises a housing part with a surface and a component which is firmly bonded with the surface of the housing part, wherein at least one of the housing part and the component is at least partly manufactured by additive manufacturing.

A method for manufacturing a power semiconductor module comprises manufacturing a housing part and manufacturing a component, wherein at least one of the housing part and the component is at least partly manufactured by additive manufacturing.

The power semiconductor modules and methods for producing the same may be better understood with reference to the following drawings and description. The features in the figures are not necessarily to scale, emphasis instead being placed upon illustrating the principles of the invention. Moreover, in the figures, like referenced numerals designate corresponding parts throughout different views.

### BRIEF DESCRIPTION OF THE DRAWINGS

Figure 1 is a schematic view illustrating a laser melting device.
Figure 2 is a schematic view illustrating a device for fused deposition molding.
Figure 3 is an isometric view illustrating pins which are firmly bonded with a housing part of a power semiconductor module.
Figure 4 is an isometric view illustrating a locking hook that is firmly bonded with the housing part of the power semiconductor module.
Figure 5 is an isometric view illustrating a rib that is firmly bonded with the housing part of the power semiconductor module.
Figure 6 is an isometric view illustrating a compensation layer that is firmly bonded with the housing part of the power semiconductor module.
Figure 7 is a detailed view illustrating the compensation layer shown in Figure 6.
Figure 8 is a flow chart illustrating a first exemplary method of manufacturing a power semiconductor module.
Figure 9 is a flow chart illustrating a second exemplary method of manufacturing a power semiconductor module.
Figure 10 is a flow chart illustrating a third exemplary method of manufacturing a power semiconductor module.

### DETAILED DESCRIPTION

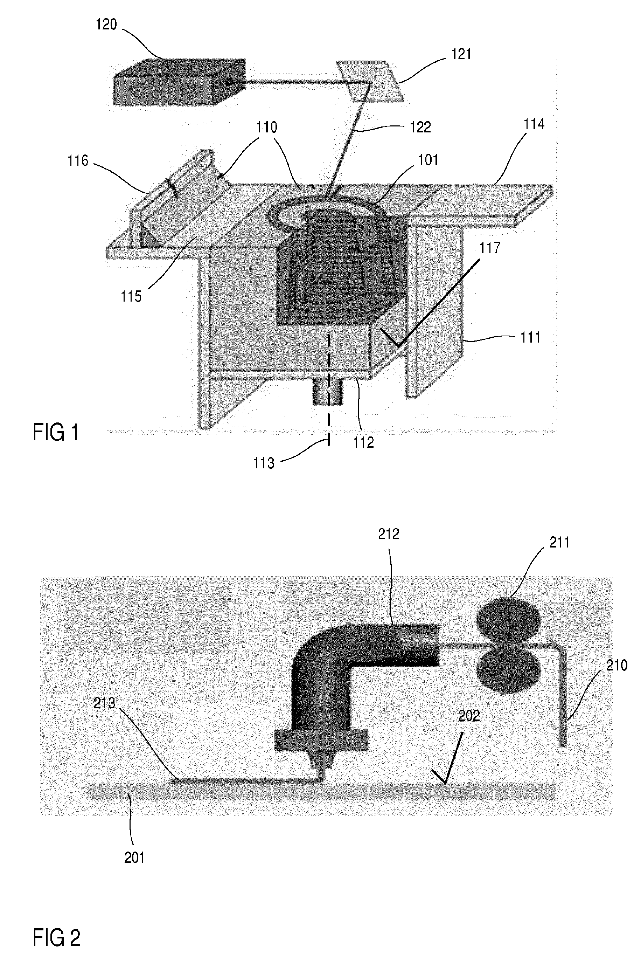

Figure 1 is a schematic view illustrating a device for laser melting or laser sintering. The device includes a mold 111 in the form of a hollow cuboid wherein the cuboid is open on a first side. A piston 112 with a first surface 117 is arranged in the mold 111 and is moveable along a first axis 113, wherein the first axis 113 is perpendicular to the first side of the mold 111. Next to the first side of the mold 111, guide areas 114 and 115 are arranged on the mold 111. The guide areas 114 and 115 guide a wiper 116 that can be moved over the guide areas 114 and 115 and the first side of the mold 111. During the movement of the wiper 116 a layer of material 110 is applied to the first surface 117 of the piston 112. The material 110 may be plastic, metal, ceramic or a combination thereof, and may be in powder form. Applying means to put a layer onto a surface of a workpiece and to firmly bond the material with the surface of the workpiece. A first layer of a workpiece may be put onto the first surface 117 of the piston 112.

The device shown in Figure 1 further includes a laser source 120 which emits laser light 122. The laser light 122 is directed to the applied material 110 by a moveable mirror 121 and partially melts the powder material 110. Consequently the powder material melds both in a direction that is parallel and in a direction that is perpendicular to the first surface 117 of the piston 112. By moving the mirror 121, the laser light 122 is moved along a predetermined contour over the powder material 110. The movement of the mirror 121 may be controlled by a controller (not shown). After that the powder material 110 is melded along this contour and a first layer of a workpiece 101 is finished. The first layer of the workpiece 101 may also be a plastic preform. In this case the piston 112 extends out of the first side of the mold 111 at a predetermined distance and a further layer may be applied onto the first layer, wherein the first layer and the further layer are firmly bonded. The procedural steps may be repeated until the workpiece 101 is completely finished. At the end, the remaining powder material 110 may be removed with compressed air. Possible layer thicknesses achievable by laser sintering may be in the range from 0.001 to 0.3 millimeters.

Figure 2 is a schematic view illustrating a device for fused deposition molding. The device shown in Figure 2 handles a thread 210 of thermoplastic material which is ejected steadily from a heated nozzle 212 by driven rundles 211. To manufacture a workpiece, the heated nozzle 212 is configured to move at least parallel or perpendicular to a surface 202 of the carrier 201. For example, the heated nozzle 212 may be mechanically connected to a manipulator (not shown) with a controller and may be moved thereby. The heated nozzle 212 may follow a predetermined contour wherein data of the predetermined contour is stored in the controller of the manipulator.

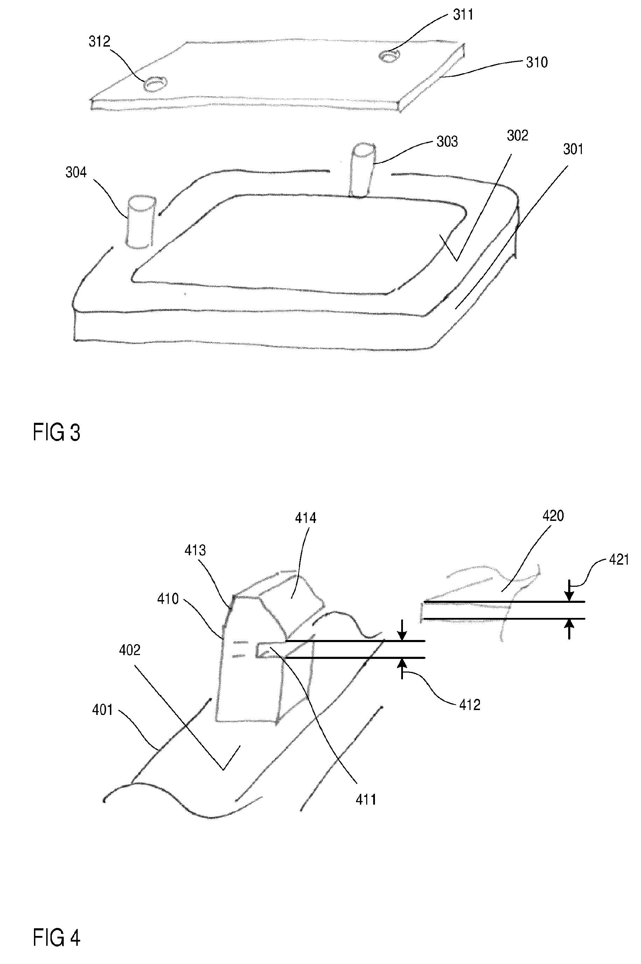

The thread 210 of thermoplastic material melts in the heated nozzle 212 and a path 213 of thermoplastic material is applied to the surface 202 of the carrier 201 by the heated nozzle 212. The path 213 may be of straight or curved shape. After finishing the path 213, the heated nozzle 212 may be raised to a predetermined extent and a further path will be applied onto the path 213 of thermoplastic material and firmly bonded thereon. The procedural steps may be repeated until the workpiece is completely finished. After finishing the workpiece, it may be demolded from the carrier 201, e.g. with compressed air. Figures 3-7 are isometric views illustrating different examples of power semiconductor modules wherein the power semiconductor modules include one or more housing parts with one or more components firmly bonded with surfaces of the housing parts of the power semiconductor module. The housing parts or the components or both are at least partly manufactured by additive manufacturing and may be at least partly made of plastic, metal or ceramic. The housing parts and the components may include different materials. Additive manufacturing may include at least one of selective laser melting, selective laser sintering, stereolithography or fused deposition modeling or a combination thereof. The components may be manufactured in conjunction with the housing parts. Alternatively, the components may be completely manufactured and after that, they may be bonded onto the surface of the housing parts in a further procedural step. To improve the positive material joint between the housing parts and the components, the surfaces of the housing parts may be at least partly sanded before the components are bonded onto the surfaces of the housing parts. The components may include pins, locking hooks, ribs or compensation layers.

Figure 3 is an isometric view illustrating a first exemplary power semiconductor module. A housing part 301 includes a surface 302 with one or more pins 303 and 304 which are applied onto the surface 302. The pins 303 and 304 may be cylindrical bolts. A housing part 310 includes one or more holes 311 and 312. The pins 303 and 304 may be firmly bonded with the surface 302 of the housing part 301 and may be configured to receive the holes 311 and 312. The pins 303 and 304 may be register pins, which are pins that fit exactly in the holes 311 and 312. Alternatively, the pins 303 and 304 may be at least formfitted or force-fitted in the holes 311 and 312. In this manner, the housing part 301 and the housing part 310 may be joined together in predetermined position and orientation.

Figure 4 is an isometric view illustrating a locking hook 410 that is applied to a surface 402 of a housing part 401. The locking hook 410 may be a cuboid, a cylinder or a cross. The side of the locking hook 410 that is opposite to the surface 402 of the housing part 401 may include one or more chamfers 413 and 414. The chamfers 413 and 414 facilitate the joining of the housing part 401 with a further housing part. The locking hook 410 may include a groove 411 with a groove width 412, the groove 411 being arranged parallel to the surface 402 of the housing part 401. The groove 411 may be configured to accommodate a printed circuit board 420 with a board thickness 421 and may be adapted thereto. For example, the groove width 412 has the same measurement as the board thickness 421 and the printed circuit board 420 may be plugged into the groove 411. Thus the printed circuit board 420 is at least positively connected to the groove 411.

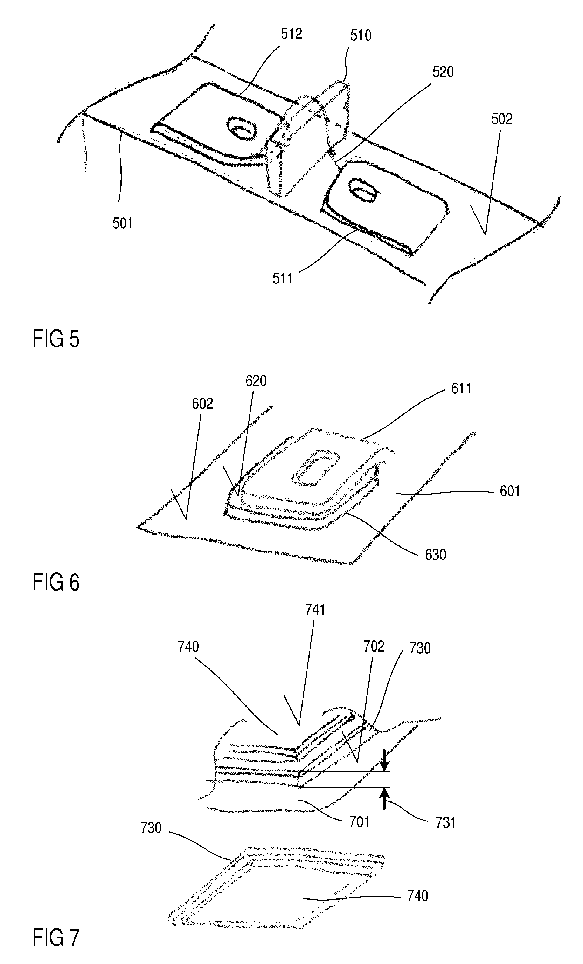

Figure 5 is an isometric view of a second exemplary power semiconductor module. The power semiconductor module includes a rib 510 which is applied to a surface 502 of the housing part 501. The rib 510 may be a cuboid with a long side, a shorter side and a height, wherein the long side may be much longer than both the shorter side and the height. The long side of the rib 510 may be firmly bonded with the surface 502 of the housing part 501. Load current terminals 511 and 512 or control terminals may be mechanically connected to the surface 502 of the housing part 501. The rib 510 is placed between the load current terminals 511 and 512. Thus the load current terminals 511 and 512 are separated by the rib 510. The rib 510 may serve to increase at least a clearance or a creepage distance 520. The creepage distance 520 is the shortest distance with the lowest electrical resistivity between the two load current terminals 511 and 512. For example, an increase of the creepage distance 520 may be achieved by increasing an electrical resistance between the load current terminals 511 and 512 using the rib 510. The rib 510 may act as a dielectricum. Subsequently, the creepage distance 520 is determined by the rib 510.

In a third exemplary power semiconductor module shown in Figure 6, a housing part 601 with a surface 602 includes a compensation layer 630. The compensation layer 630 is applied to the surface 602 of the housing part 601 and may have a predetermined thickness corresponding to a thickness of a first substrate (not shown) of the power semiconductor module. Thus a height of a load current terminal 611 may be adjusted by the compensation layer 630.

Figure 7 is an isometric view illustrating a fourth exemplary power semiconductor module. A compensation layer 730 is configured to adjust a height of a housing part 701 to a thickness of a second substrate 740. In this example, the second substrate 740 is thinner than a third substrate (not shown). The compensation layer 730 with a thickness 731 is applied to a surface 702 of the housing part 701. The thickness 731 of the compensation layer 730 may be chosen in a way that the shortest distance between the surface 702 of the housing part 701 and a first surface 741 of the second substrate 740 is the same as between a first surface of the third substrate and the surface 702 of the housing part 701. Thus the first surface 741 of the second substrate 740 may have the same height in relation to the housing part 701 as the third substrate with a greater thickness.

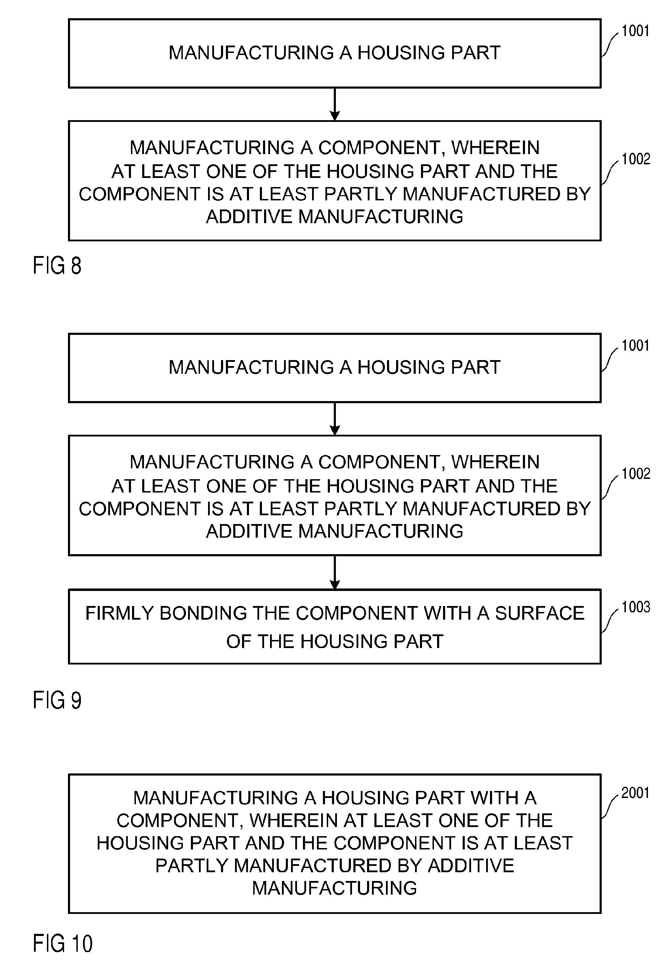

Figure 8 is a flow chart illustrating a first exemplary method of manufacturing a power semiconductor module that includes at least the procedural steps of manufacturing 1001 a housing part 301; 401; 501; 601 and 701 and manufacturing 1002 a component, wherein at least one of the housing part 301; 401; 501; 601 and 701 and the component is at least partly manufactured by additive manufacturing.

Figure 9 is a flow chart illustrating a second exemplary method of manufacturing a power semiconductor module. The method shown in Figure 8 may further include a procedural step of firmly bonding 1003 the component with a surface 302, 402; 502; 602 and 702 of the housing part 301; 401; 501; 601 and 701. Additive manufacturing may include at least one of selective laser melting, selective laser sintering, stereolithography or fused deposition modeling or a combination thereof.

Figure 10 is a flow chart illustrating a third exemplary method of manufacturing a power semiconductor module. The method includes a single procedural step of manufacturing 2001 a housing part 301; 401; 501; 601 and 701 with a component, wherein at least one of the housing part 301; 401; 501; 601 and 701 and the component is at least partly manufactured by additive manufacturing. The housing part 301; 401; 501; 601 and 701 with the component may be manufactured as a single piece.

The features mentioned in the single embodiments of the power semiconductor module component may also be combined in different ways. Therefore, features may also be omitted or added in different embodiments of the power semiconductor module component.

The description of embodiments has been presented for purposes of illustration and description. Suitable modifications and variations to the embodiments may be performed in light of the above description or may be acquired from practicing the methods. For example, unless otherwise noted, one or more of the described methods may be performed by a suitable device and/or combination of devices. The described methods and associated actions may also be performed in various orders in addition to the order described in this application, in parallel, and/or simultaneously. The described systems are exemplary in nature, and may include additional elements and/or omit elements.

As used in this application, an element or step recited in the singular and proceeded with the word "a" or "an" should be understood as not excluding plural of said elements or steps, unless such exclusion is stated. Furthermore, references to "one embodiment" or "one example" of the present disclosure are not intended to be interpreted as excluding the existence of additional embodiments that also incorporate the recited features. The terms "first," "second," and "third," etc. are used merely as labels, and are not intended to impose numerical requirements or a particular positional order on their objects.

While various embodiments of the invention have been described, it will be apparent to those of ordinary skilled in the art that many more embodiments and implementations are possible within the scope of the invention. In particular, the skilled person will recognize the interchangeability of various features from different embodiments. Although these techniques and systems have been disclosed in the context of certain embodiments and examples, it will be understood that these techniques and systems may be extended beyond the specifically disclosed embodiments to other embodiments and/or uses and obvious modifications thereof.

## Claims

1. A power semiconductor module comprising:
a housing part (301; 401; 501; 601; 701) with a surface (302; 402; 502; 602; 702);
a component which is firmly bonded with the surface (302; 402; 502; 602; 702) of the housing part (301; 401; 501; 601; 701), wherein
at least one of the housing part (301; 401; 501; 601; 701) and the component is at least partly manufactured by additive manufacturing.

2. The power semiconductor module of claim 1, wherein at least one of the housing part (301; 401; 501; 601; 701) and the component is completely or partly made of plastic, metal or ceramic.

3. The power semiconductor module of claim 1 or 2, wherein the component is at least one of a pin (303; 304), a locking hook (410), a rib (510) or a compensation layer (630; 730).

4. The power semiconductor module of claim 3, further comprising:
at least two load current terminals (331; 332) or two control terminals that are applied to the surface (302; 402; 502; 602; 702) of the housing part (301; 401; 501; 601; 701) and that are separated by the rib (510).

5. The power semiconductor module of claim 3, wherein the compensation layer (630) adjusts the height of a load current terminal (611) or a control terminal of the power semiconductor module to a thickness of a first substrate.

6. The power semiconductor module of claim 3, wherein the compensation layer (630; 730) adjusts a height of the housing part (301; 401; 501; 601; 701) to a thickness of a second substrate (740).

7. The power semiconductor module of claim 3, wherein the locking hook (410) includes a groove (411).

8. The power semiconductor module of claim 7, further comprising:
a printed circuit board that is plugged into the groove (411) of the locking hook (410).

9. The power semiconductor module as claimed in one of claims 1-8, wherein additive manufacturing includes at least one of selective laser melting, selective laser sintering, stereolithography or fused deposition modeling.

10. A method for manufacturing a power semiconductor module, the method comprising:
manufacturing (1001) a housing part (301; 401; 501; 601; 701);
manufacturing (1002) a component, wherein
at least one of the housing part (301; 401; 501; 601; 701) and the component is at least partly manufactured by additive manufacturing.

11. The method of claim 10, the method further comprising:
firmly bonding (1003) the component with a surface (302; 402; 502; 602; 702) of the housing part (301; 401; 501; 601; 701).

12. A method for manufacturing a power semiconductor module, the method comprising:
manufacturing (2001) a housing part (301; 401; 501; 601; 701) with a component, wherein
at least one of the housing part (301; 401; 501; 601; 701) and the component is at least partly manufactured by additive manufacturing.

## Amended claims

### Amended claims in accordance with Rule 137(2) EPC.

1. A power semiconductor module comprising:
a housing part (301; 401; 501; 601; 701) with a surface (302; 402; 502; 602; 702);
a component which is firmly bonded with the surface (302; 402; 502; 602; 702) of the housing part (301; 401; 501; 601; 701), and which forms a material joint between the housing part (301; 401; 501; 601; 701) and the component, wherein
at least one of the housing part (301; 401; 501; 601; 701) and the component is at least partly manufactured by additive manufacturing.

2. The power semiconductor module of claim 1, wherein at least one of the housing part (301; 401; 501; 601; 701) and the component is completely or partly made of plastic, metal or ceramic.

3. The power semiconductor module of claim 1 or 2, wherein the component is at least one of a pin (303; 304), a locking hook (410), a rib (510) or a compensation layer (630; 730).

4. The power semiconductor module of claim 3, further comprising:
at least two load current terminals (331; 332) or two control terminals that are applied to the surface (302; 402; 502; 602; 702) of the housing part (301; 401; 501; 601; 701) and that are separated by the rib (510).

5. The power semiconductor module of claim 3, wherein
the compensation layer (630) has a first height, and
the power semiconductor module comprises a load current terminal (611) or a control terminal having a second height and being arranged above the compensation layer (630) such that the compensation layer (630) adjusts the height of the load current terminal (611) or a control terminal of the power semiconductor module to a third height which corresponds to the thickness of a first substrate.

6. The power semiconductor module of claim 3, wherein
the compensation layer (630; 730) has a first thickness,
the compensation layer (630, 730) is arranged on the surface (302; 402; 502; 602; 702) of the housing part, and
the first thickness is chosen such that the shortest distance between the surface (302; 402; 502; 602; 702) of the housing part (301; 401; 501; 601; 701) and a first surface (741) of a second substrate (740) is the same as a distance between the surface (302; 402; 502; 602; 702) of the housing part (301; 401; 501; 601; 701) and a first surface of a third substrate, wherein the second substrate is thinner than the third substrate.

7. The power semiconductor module of claim 3, wherein the locking hook (410) includes a groove (411).

8. The power semiconductor module of claim 7, further comprising:
a printed circuit board that is plugged into the groove (411) of the locking hook (410).

9. The power semiconductor module as claimed in one of claims 1-8, wherein additive manufacturing includes at least one of selective laser melting, selective laser sintering, stereolithography or fused deposition modeling.

10. A method for manufacturing a power semiconductor module, the method comprising:
manufacturing (1001) a housing part (301; 401; 501; 601; 701);
manufacturing (1002) a component; and
firmly bonding (1003) the component with a surface (302; 402; 502; 602; 702) of the housing part (301; 401; 501; 601; 701) such that a material joint is formed between the housing part (301; 401; 501; 601; 701) and the component, wherein
at least one of the housing part (301; 401; 501; 601; 701) and the component is at least partly manufactured by additive manufacturing.
